# EUROPEAN PATENT APPLICATION

(11) **EP 2 334 158 A1**
(43) Date of publication of application: **15.06.2011**
(21) Application number: 09252760.5
(22) Date of filing: 10.12.2009
(51) Int. Cl.: H05K 1/14, H05K 3/34, H01L 23/00, H05K 7/00

(54) **Bridge coupling of modules in an electronic device**

(71) Applicant: ST-Ericsson SA, Geneva (CH)
(72) Inventor: Slavov, Nedialko, 8057 Zurich (CH)
(74) Representative: Gray, Peter John Bracey

(57) **Abstract**

An electronic device (201) and a module (202) for an electronic device (201) are disclosed, together with method of manufacturing the same. Each module (202) comprises a substrate (203) having an upper surface (208) to which an integrated circuit die (204) is mounted. In preferred embodiments, a solder ball (214) is mounted to the upper surface (208) of the substrate (203) in such a manner that, on melting, a flow of molten solder extends from the solder ball (214) over the edge of the substrate (203). In this manner, an electrical connection between adjacent modules (202) can be formed the connection of molten solder flowing from a solder ball (214) on each of the modules (202).

## Description

### Field of the Disclosure

The present disclosure relates to an electronic device, a module for an electronic device, and to methods of manufacturing the electronic device and module. In particular, but not exclusively, the disclosure relates to coupling modules of an electronic device to one another.

### Background to the Disclosure

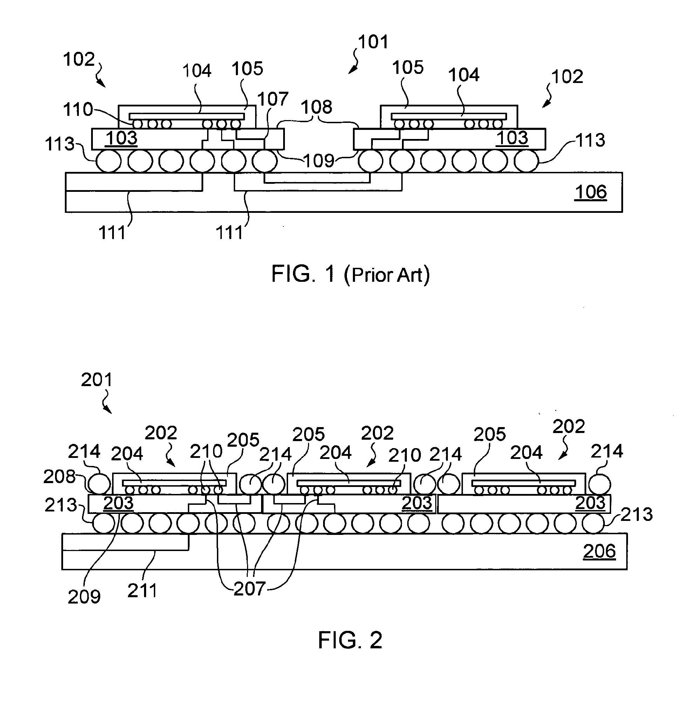

Referring to Figure 1, an electronic device 101 fabricated according to modern semiconductor process specifications may comprise a plurality of modules 102. Each module 102 typically comprises a substrate 103 supporting an integrated circuit die 104 that is housed in a moulding 105. Each of the modules 102 is mounted to a single carrier 106, typically being a printed circuit board (PCB).

In each module 102, the substrate 103 has electrically conductive elements 107 that extend from an upper surface 108 to a lower surface 109. The integrated circuit die 104 has electrically conductive bumps 110 that electrically couple the integrated circuit die 104 to the electrically conductive elements 107 at the upper surface 108 of the substrate 103. The carrier 106 has electrically conductive tracks 111 extending between different locations on an upper surface. Solder balls 113 electrically couple the electrically conductive elements 107 at the lower surface 109 of the substrate 103 to the electrically conductive tracks 111 at the different locations. In this way, the integrated circuit die 104 of one of the modules 102 is electrically coupled to the integrated circuit die 104 of another one of the modules 102.

For clarity purposes, only subsets of the electrically conductive elements 107 and electrically conductive tracks 111 are shown in Figure 1. In particular, in a typical electronic device 101, the number of electrically conductive tracks 111 in the carrier 106 is much greater than the number shown in Figure 1. As the number of electrically conductive tracks 111 increases, so does the possibility of cross-talk between different electrically conductive tracks 111. Moreover, the severity of this effect is increased as the frequency at which electronic device 101 operates is increased and the size of the electronic device 101 is reduced. Furthermore, there is a relatively long electrical path length between the integrated circuit die 104 of the different modules 102 and this can be a limiting factor on the speed of the electronic device 101.

Modern semiconductor processes allow highly complex devices 101 to be created using a single carrier 106. These devices 101 may use analog, digital and mixed signal processes and require a large number of integrated circuit dies 104 to be coupled to the carrier 106. The complexity of such devices 101 is increasing all the time and, as a result, so too is the number of signals which need to be carried between the various individual integrated circuit dies 104 on the carrier 106. Accordingly, the number of electrically conductive tracks 111 in the carrier 106 is also increasing.

As the drive to increase the speed and reduce the size of electronic devices 101 continues, the efficiency of the electrically conductive tracks 111 between various integrated circuit dies 104 in the device 101 is becoming a major limiting factor. For example, miniaturisation of devices 101 leads to higher density electrically conductive tracks 111 in the carrier 106 which can result in detrimental effects such as cross-talk between the signals propagating in the electrically conductive tracks 111. This compromises the functionality of the device 101. The difficulties presented by cross-talk become more severe in devices 101 operating at greater speeds.

In addition to these difficulties, the electrically conductive tracks 111 themselves represent a significant path length for the signals to traverse, placing limits on the speed of the device 101. Although this problem can be limited somewhat by increasing the density of modules 102 in the device 101, this leads to cross-talk between electrically conductive tracks 111 as explained above.

Even if cross-talk between electrically conductive tracks 111 can be overcome, there are difficulties in miniaturising the device 101 to the desired level. For example, as mentioned above the electrically conductive tracks 111 are coupled to the substrate 103 via a plurality of solder balls 113. A separate solder ball 113 is required to connect each electrically conductive track 111 to the substrate 103 and in many cases a large number of connections are required for a given substrate 103. Accordingly, the size of these solder balls 113 can be a limiting factor in the miniaturisation of the device 101, especially when relatively small integrated circuit dies 104 must be provided with signals from a large number of electrically conductive tracks 111.

It is vital in many applications that electronic devices 101 are miniaturised. For example, many applications of solid state data storage drives require significant storage (and therefore large numbers of integrated circuit dies providing memory) in a relatively small space. Storage drives of this type may be required in mobile phones, mobile personal computers and portable media players, for example. The limitations on the miniaturisation of electronic devices 101 outlined above therefore represent a serious hurdle for the industry.

A number of efforts have been made to mitigate the above problems. For example, high electrically conductive track 111 density packages have been produced. These packages employ a small pitch (400um or below) for the solder balls 113 coupling the substrate 103 to the carrier 106 and also employ advanced substrate fabrication technology to allow a high density of electrically conductive elements 107 to be formed through the substrate 103 itself. However, the cost of implementing such high density packages is prohibitive and the problem of cross-talk between the electrically conductive tracks 111 remains. Moreover, although the electrically conductive tracks 111 are packed at high density they still remain relatively long and are therefore a drag on the potential speed of the device.

Multilayer technologies have also been proposed. In these devices, each integrated circuit die 104 is sandwiched between a ground plane and a transmission line. This architecture can be repeated a number of times to provide a number of layers of integrated circuit dies 104. The electrically conductive tracks 111 between the integrated circuit dies are established through both the ground plane and the transmission line. As such, the electrically conductive tracks 111 are separated into distinct layers, reducing the risk of cross-talk. However, devices formed in this manner are relatively large. Moreover, the cost of fabricating multilayer devices is relatively high.

Another approach that has been suggested is known as a package on package (PoP) architecture. In PoP architecture, two integrated circuit dies 104 are mounted above a single area of a carrier 106, one above, the other. A common application of this technique, which occurs particularly in the field of mobile telecommunications, is the mounting of an integrated circuit die 104 providing memory above an integrated circuit die 104 acting as a controller. Accordingly, the physical distance between the controller and the memory is reduced, as is the size of the carrier 106 required to support both these integrated circuit dies 104. However, there are a number of disadvantages with PoP architecture. For example, access to the upper integrated circuit die to the carrier 106 must pass through the substrate 103 on which the lower integrated circuit die is mounted. Accordingly, the density of the solder balls 113 connecting the substrate 103 to the carrier 106 is increased, thereby increasing the density of the electrically conductive tracks 111 in the carrier 106 and the corresponding risk of cross-talk. Moreover, this approach raises problems associated with the manufacture of high density connections, leading to increased expense.

### Summary of the Preferred Embodiments

According to a first aspect, there is provided a module for an electronic device, the module comprising:
a substrate having an upper surface upon which an integrated circuit die is supported;
a solder ball provided on the upper surface of the substrate; and
a guide arranged to direct a flow of molten solder from the solder ball over an edge of the substrate.

According to a second aspect, there is provided a method of manufacturing a module for an electronic device, the method comprising:
providing a substrate having an upper surface upon which an integrated circuit die is supported;
providing a solder ball on the upper surface of the substrate; and
forming a guide arranged to direct a flow of molten solder from the solder ball over an edge of the substrate.

The first and second aspects provide a solder ball on the same surface of the substrate as an integrated circuit die is supported. The solder ball can be used to establish a connection with other modules which are adjacent to the module on which the solder ball is provided. Such a connection does not require signals to pass through a carrier of the module, such as a printed circuit board (PCB), thereby reducing cross-talk and other interference effects in any such carrier. Moreover, the connection may have a relatively short path length, thereby reducing the delay in signals transmitted from or to the integrated circuit die.

In particular, the solder ball may be connected to a corresponding solder ball on an adjacent module. In this way, a connection between the two modules is formed. In order to secure this connection, the solder ball and the corresponding solder ball may be melted so that they combine. The guide ensures that, on melting, the solder ball flows towards the edge of the substrate so as to enable it to form a connection with other modules beyond the substrate. Moreover, the guide is preferably arranged to inhibit the flow of molten solder from the solder ball in directions away from the edge of the substrate. As a result, the guide can prevent the solder ball from melting in other directions on the upper surface of the substrate which might result in short circuits with other contacts provided.

In some preferred examples, the guide comprises a channel. For example, the guide may comprise a depressed region of the upper surface extending from the solder ball to the edge of the substrate. In this way, on melting, solder from the solder ball will tend to flow along the channel towards the edge of the substrate. Preferably, the channel comprises a gap between two regions of solder mask.

In other preferred examples, the guide may alternatively or additionally comprise a moulding at least partially surrounding the solder ball, the moulding having an opening between the solder ball and the edge of the substrate. The moulding guides molten solder to the edge of the substrate and inhibits the flow of molten solder in unwanted directions, thereby reducing the chance that accidental connections will be formed. In order to allow solder to melt towards and beyond the edge of the substrate an opening is provided on a surface of the moulding disposed towards the edge of the substrate. As such, the method preferably further comprises forming a moulding at least partially surrounding the solder ball, the moulding having an opening between the solder ball and the edge of the substrate. In preferred examples, the opening between the solder ball and the edge of the substrate is formed by cutting the moulding.

Another opening is also preferably provided in an upper surface of the moulding. Accordingly, the method preferably further comprises forming another opening in an upper surface of the moulding. In preferred examples, the step of forming an opening in an upper surface of the mould comprises grinding the moulding. The opening in the upper surface of the moulding allows heat to be more easily applied to the solder ball. Moreover, the presence of an opening on the upper surface can assist in the flow of molten solder through the opening in the moulding between the solder ball and the edge of the substrate. This is because the opening in the upper surface of the moulding allows air to enter the cavity in the moulding which is created as molten solder flows out.

In preferred examples, the integrated circuit die is disposed within a/the moulding. This allows the integrated circuit die to be securely mounted to the substrate, and provides a compact design when the integrated circuit die is disposed within the same moulding which is used as the guide. Nevertheless, separate mouldings may be used to mount the integrated circuit die and to act as the guide if appropriate.

Preferably, the solder ball is electrically coupled to the integrated circuit die.

Typically, the module further comprises one or more further solder balls disposed on a lower surface of the substrate, the lower surface being opposite to the upper surface. This allows the device to be connected to a carrier, such as a PCB. The further solder balls can also be used to provide connections to other modules. In this case, this can be achieved by providing electrically conductive tracks through the carrier.

As mentioned above, the solder ball on the upper surface of the substrate can preferably be used to connect with another module. Accordingly, there may be provided first and second modules, each being a module according to the first aspect, wherein the first and second modules are disposed on a carrier adjacent to each other such that the guides of the first and second modules are arranged to direct the flows of molten solder towards one another.

Similarly, a method of manufacturing an electronic device can comprise providing first and second modules by the method of the second aspect, and disposing the first and second modules on a carrier adjacent to each other such that the guides of the first and second modules are arranged to direct the flows of molten solder towards one another.

More preferably, the method further comprises heating the solder balls such that they melt to provide the flows of molten solder so as to form an electrical connection between the first and second modules. The electrical connection preferably comprises a bridge extending between the upper surface of the substrate of the first module and the upper surface of the substrate of the second module.

Indeed, the electrical connection of the upper surface of substrates in this way is considered to be novel in of itself. As such, according to a third aspect, there is provided an electronic device comprising:
a first module having a first substrate having with an upper surface upon which a first integrated circuit die is supported;
a second module having a second substrate with an upper surface upon which a second integrated circuit die is supported; and
an electrical connection comprising a bridge extending between the upper surface of the first substrate and the upper surface of the second substrate.

Moreover, according to a fourth aspect, there is provided a method for manufacturing an electronic device, the method comprising:
providing a first module having a first substrate having with an upper surface upon which a first integrated circuit die is supported;
providing a second module having a second substrate with an upper surface upon which a second integrated circuit die is supported; and
forming an electrical connection comprising a bridge extending between the upper surface of the first substrate and the upper surface of the second substrate.

The connections between the upper surfaces of the substrates in the third and fourth aspects can enable communication between the integrated circuit dies without the need for signals to travel through a carrier on which the substrates are mounted. This reduces the risk of cross-talk with other signals carried by the carrier and also limits the path length signals need to travel between the integrated circuit dies, thereby increasing the speed of the device.

The first and second substrates are preferably disposed on a carrier adjacent to each other. That is to say, the first and second substrates are disposed side by side. In some examples, this may mean that the upper surfaces of the first and second substrates are disposed in the same plane. The arrangement of the first and second substrates further reduces the distance covered by the electrical connection and allows the speed of the device to be increased.

In preferred examples, the electrical connection is solder. More preferably, forming the electrical connection comprises heating solder balls provided on the first and second upper surfaces such that they melt to provide flows of molten solder that extend over edges of the first and second substrates.

The skilled person will appreciate that the guide and other preferred features of the first and second aspects may equally be applied to the third and fourth aspects.

### Brief Description of the Drawings

Preferred embodiments are described below, by way of example only, with reference to the accompanying drawings, in which:
Figure 1 is a schematic sectional view of an electronic device according to the prior art;
Figure 2 is a schematic sectional view of an electronic device prior to the application of a heating step;
Figure 3 is a schematic sectional view of the electronic device of Figure 2 after the application of the heating step;
Figure 4 is a schematic sectional view of a module for an electronic device according to a first embodiment of the present disclosure;
Figure 5 is a schematic sectional view of a module for an electronic device according to a second embodiment of the present disclosure;
Figure 6 is a schematic sectional view of the module shown in Figure 4 at a first stage during manufacture of the module;
Figure 7A is a schematic sectional view of the module shown in Figure 4 at a second stage during manufacture of the module;
Figure 7B is a schematic sectional view of the module shown in Figure 4 at a third stage during manufacture of the module;
Figure 8A is a schematic sectional view of a portion of the module shown in Figure 4 at the third stage during manufacture of the module, illustrating a removable portion of the upper solder mask;
Figure 8B is a schematic sectional view of a portion of the module shown in Figure 4 at the third stage during manufacture of the module, illustrating a removable portion of the upper solder mask and a position at which the module will be cut;
Figure 9 is a schematic birds-eye view of a plurality of solder balls in the module shown in Figure 4;
Figure 10A is a schematic sectional view of a portion of the module shown in Figure 5 at a first stage during manufacture of the module;
Figure 10B is a schematic sectional view of a portion of the module shown in Figure 5 at a second stage during manufacture of the module;
Figure 11A is a schematic sectional view of an electronic device comprising two of the modules shown in Figure 5 prior to the application of a heating step; and
Figure 11 B is a schematic sectional view of an electronic device comprising two of the modules shown in Figure 5 after the application of a heating step.

### Detailed Description

Referring to Figure 2, an electronic device 201 comprises three modules 202. In each module 202, an integrated circuit die 204 is provided and supported within a moulding 205 which is in turn mounted on an upper surface 208 of a substrate 203. A number of conductive bumps 210 are provided to electrically couple the integrated circuit die 204 and the substrate 203. The substrate 203 is in turn mounted to a carrier 206 by a number of solder balls 213 disposed on a lower surface 209 of the substrate 203. Electrically conductive elements 207 are provided through the substrate 203 from the conductive bumps 210 to the solder balls 213. Electrically conductive tracks 211 are provided to couple the solder balls 213 through the carrier 206 to other modules external to the electronic device 201.

The modules 202 illustrated in Figure 1 further include solder balls 214 on the upper surface 208 of the substrate 203. Each of the solder balls 214 on the upper surface 208 of the substrate 203 is electrically coupled to a conductive bump 210 through an electrically conductive element 207 provided through the substrate 203.

The modules 202 are disposed adjacent to each other and the solder balls 214 on the upper surface 208 of the substrates 206 are disposed proximate to an edge of the substrate 206 on which they are provided. As such, each of these solder balls 214 is relatively close to a corresponding solder ball 214 on an adjacent module 202. The modules 202 are relatively near to each other, thereby increasing the proximity of corresponding solder balls 214. Moreover, the upper surfaces 208 of the substrates 203 are level, i.e. disposed in the same plane, which also increases the proximity of corresponding solder balls 214.

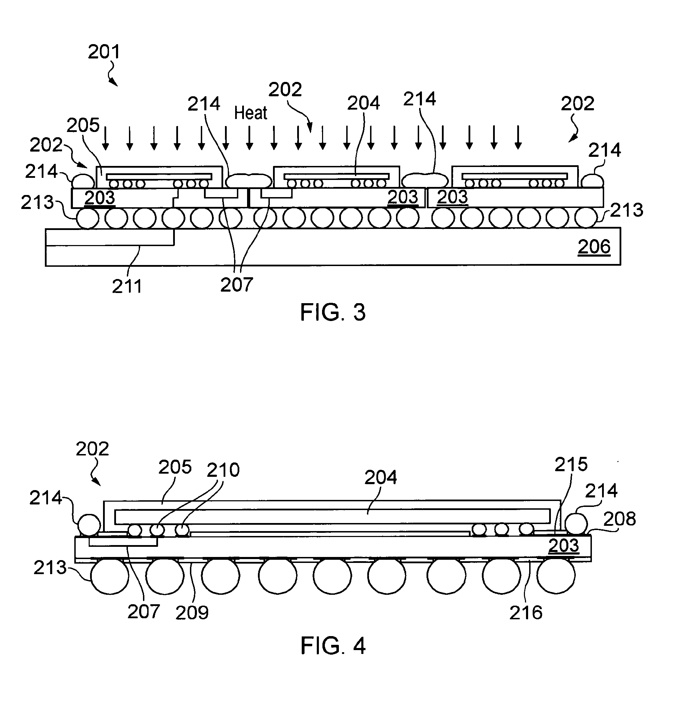

Figure 3 shows the electronic device 201 of Figure 2 after the application of heat from above. As can be seen in Figure 3, the heat causes the solder balls 214 to melt and form a connection with corresponding adjacent solder balls 214. In effect, a solder bridge is formed by the melting of corresponding solder balls 214. This bridge allows adjacent modules 202 to be electrically coupled.

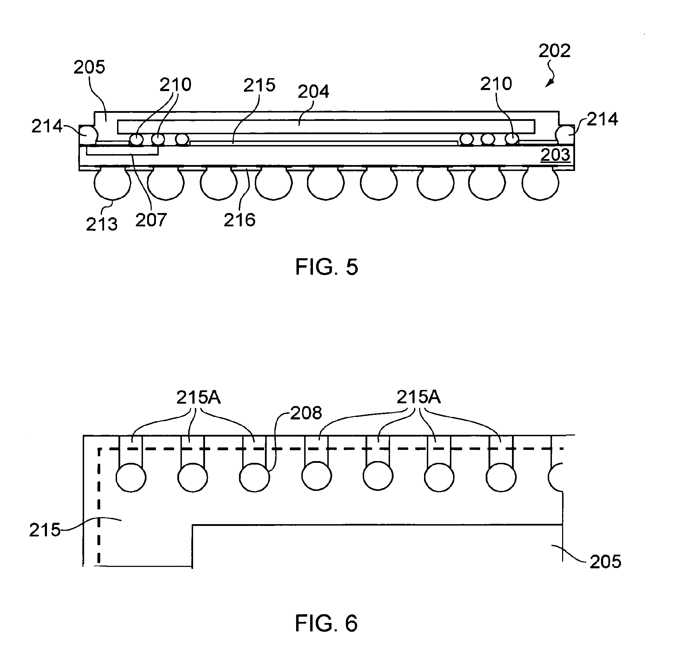

As will be described in greater detail below with reference to Figures 4 and 5, each module 202 preferably comprises a guide arranged to direct a flow of molten solder from the solder balls 214 over an edge of the substrate 203. Moreover, the guide also acts to inhibit flow of molten solder from the solder balls 214 in directions away from the edge of the substrate 203. That is to say, the guide encourages solder to melt in a preferred direction. As a result, an effective connection between solder balls 214 on adjacent modules can be established and, moreover, the risk of solder melting in undesired directions across the upper surface of the substrate 203 is minimised.

Each solder ball 214 on the upper surface 208 of the substrate 203 is coupled to the integrated circuit die 204 supported by the substrate 203 on which that solder ball 214 is mounted. This coupling is achieved via the conductive bumps 210 attached to the integrated circuit die 204 and an electrically conductive element 207 provided through the substrate 203 that passes from the conductive bumps 210 to the solder ball 214. As such, once the solder bridge is formed, the upper surfaces of the substrates 213 are electrically coupled. Thus, separate modules 202 are coupled and accordingly so are separate integrated circuit dies 204. This coupling is established without the need to use electrically conductive tracks 111 in the carrier 106, such as those illustrated in Figure 1.

As the coupling between integrated circuit dies 204 established via the solder bridge does not pass through the carrier 206, the risk of cross-talk between signals passing through electrically conductive tracks 211 in the carrier 206 and signals passing through the solder balls 214 is minimal, due to the relatively large distance between them. It can also be seen that the distance that electrical signals have to travel between the modules 202 through the solder balls 214 is relatively short as compared to travelling through electrically conductive tracks 111 in the carrier 106 illustrated in the prior art shown in Figure 1. Accordingly, the solder balls 214 can be used to form a relatively fast coupling between modules 202.

Although not shown in Figures 2 or 3, further electrically conductive tracks 211 may be provided to couple solder balls 213 of the modules 202 of the electronic device 201 via the carrier 206. This provides an additional coupling between the modules 202 of the device, although this additional coupling may be relatively slow compared to the coupling via the solder balls 214 on the upper surface 208 of the substrate 203

Notably, although Figures 2 and 3 show a one dimensional array of modules 202 (i.e. a single row of modules 202), allowing one module 202 to be coupled to two additional modules 202 via couplings established by the solder balls 214, the skilled person will understand that the principles of the present disclosure could be equally applied to a two-dimensional array of modules 202. This would allow solder bridges, and therefore relatively fast couplings, to be formed between larger numbers of modules 202.

A first preferred embodiment of the module 202 illustrated in Figure 2 is shown in more detail in Figure 4.

Referring to Figure 4, the module 202 comprises an integrated circuit die 204, a moulding 205 in which the integrated circuit die 204 is supported, and a substrate 203 on which the moulding 205 is disposed. Figure 4 also shows a plurality of solder balls 213 used to mount the substrate 203 to a carrier 206. A number of conductive bumps 210 are provided between the integrated circuit die 204 and the carrier 206. Two solder balls 214 can also be seen in Figure 4 mounted to the upper surface 208 of the substrate 203.

The above features of Figure 4 are also illustrated in Figure 2. However, Figure 4 shows a number of additional details of the module 202. In particular, the substrate 203 is provided with an upper solder mask 215 and a lower solder mask 216. The upper solder mask 215 is disposed on the upper surface 208 of the substrate 203 and is provided with apertures to receive each of the solder balls 214 and the conductive bumps 210. There are further provided channels which extend from the apertures for receiving the solder balls 214 to the edge of the substrate 203. The channels provide a depressed region in the upper surface 208 of the substrate 203 along which solder can flow from the solder balls 214 to the edge of the substrate 203. This assists in the formation of the solder bridges referred to above in relation to Figure 3.

The channels provided in the upper solder mask 215 form guides which can act to direct a flow of molten solder from the solder balls 214 over the edge of the substrate 203. Moreover, the guides inhibit flow of molten solder from the solder balls 214 in directions away from the edge of the substrate 203. That is, the guides can prevent the solder balls 214 melting across in the upper surface of the substrate 203 in an uncontrolled manner. Accordingly, any risk of accidental connections being formed on the upper surface 208 of the substrate 203 is reduced.

The lower solder mask 216 includes apertures for the solder balls 213 to contact metal contacts on the lower surface 209 of the substrate 203. This ensures an adequate coupling between these solder balls 213 and the integrated circuit die 204.

A second preferred embodiment is shown in detail in Figure 5. Like reference numerals are used to denote like features of the second embodiment as compared to the first embodiment.

Referring to Figure 5, the second preferred embodiment is similar to the first embodiment in a number of features. In particular, the module 202 of the second preferred embodiment comprises an integrated circuit die 204, a moulding 205 in which the integrated circuit die 204 is supported, and a substrate 203 on which the moulding 205 is disposed. Figure 5 also shows a plurality of solder balls 213 attached to the lower surface 209 of the substrate 203 and used to mount the substrate 203 to a carrier 206. A number of conductive bumps 210 are provided between the integrated circuit die 204 and the carrier 206. Two solder balls 214 can also be seen in Figure 4 mounted to the upper surface 208 of the substrate 203.

Figure 5 also illustrates upper and lower solder masks 215, 216 provided in the second embodiment. As for the first preferred embodiment, the solder balls 214 on the upper surface 208 of the substrate 203 are received through apertures in the upper solder mask 215.

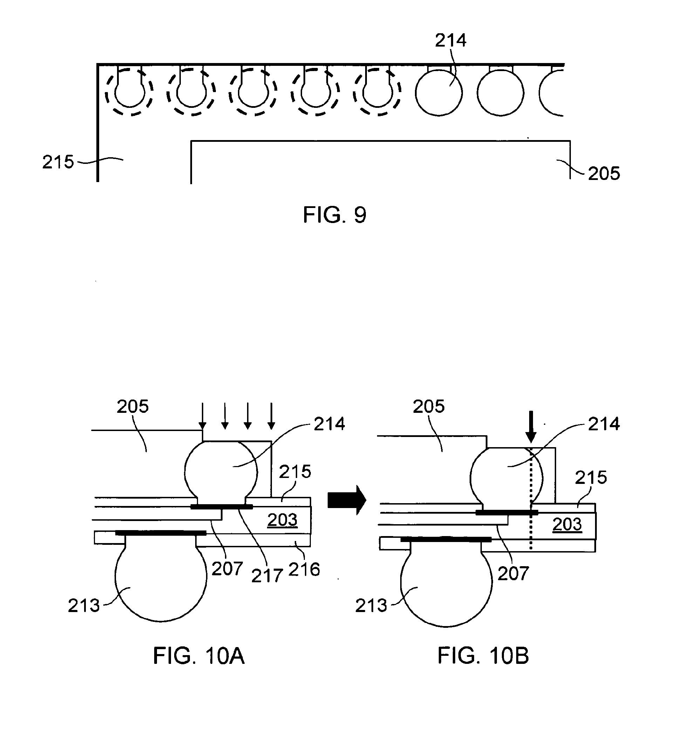

The solder balls 214 of the second preferred embodiment are disposed within the moulding 205, unlike those in the first preferred embodiment. The moulding 205 is shaped so as to coincide with one or more of the edges of the solder balls 214. The manner is which the shape of the moulding 205 is manipulated is described in more detail below with reference to Figures 10A and 10B.

In the second embodiment, the moulding 205 forms a guide which can act to direct a flow of molten solder from the solder balls 214 over the edge of the substrate 203. The moulding 205 surrounds the solder balls 214 so as prevent the solder balls 214 melting in any direction apart from towards the edge of the substrate 203. Specifically, the moulding 205 surround the solder balls 214 in three of the four directions of the along the plane of the substrate 203.

To achieve this aim, the moulding 205 comprises an opening between each solder ball 213 and the edge of the substrate 203. When heated, molten solder from a solder ball 214 passes through the appropriate opening over the edge of the substrate 203 in order to form a connection.

The moulding 205 is also provided with openings in its upper surface such that each of the solder balls 214 are exposed. This assists in the application of heat to the solder balls 214. The action of gravity ensures that, on melting, the solder balls 214 melt towards the edge of the substrate 203, rather than upwards through the openings in the upper surface of the moulding 205 through which the solder balls 214 are exposed.

An additional advantage of the openings in the upper surface of the moulding 205 is that they assist in encouraging the flow of molten solder. In particular, as molten solder flows beyond the edge of the substrate it will leave a space, or cavity, inside the moulding 205. This space must be filled if the flow is to continue. For example, this space could be filled by air. It is relatively hard to draw air in through the openings in the side of the moulding 205 through which the solder is flowing because of the high surface tension of the solder which acts to seal the opening between the solder 210 and the edge of the substrate 203. The provision of the openings in the upper surface of the moulding 205 allows the space to be filled with air while not allowing solder to flow in directions other than that desired.

The action of the guide provided by the moulding 205 ensures that each solder ball 214 is electrically isolated from other solder balls 214 and any other electrical contacts on the same module 202. At the same time, the solder ball 214 may melt in such a manner as to come into contact with electrical contacts beyond the edge of the substrate 203. In particular, a solder ball 214 on a first module 202 may melt towards a corresponding solder ball 214 on a second module 202, thereby forming an electrical connection between two modules 202 in the form of a solder bridge.

Methods of manufacturing the first and second embodiments will now be described with reference to the accompanying Figures.

The first preferred embodiment, illustrated in Figure 4, is manufactured using an upper solder mask 215 that has removable portions 215A. Figure 6 illustrates a top down view of a corner of the module 202 after the upper solder mask 215 has been applied, but before the solder balls 214 have been affixed to the substrate 203.

As can be seen in Figure 6, the substrate 203 is substantially covered by the upper solder mask 215. The upper solder mask 215 forms an upper layer of the substrate 203 and is therefore disposed below the moulding 205 for receiving the integrated circuit die 204 (this is best seen in Figure 4). A number of apertures can be seen in the upper solder mask 215 in Figure 6. These are provided for receiving the solder balls 214 at a later stage. Furthermore, removable portions 215A of the upper solder mask 215 are provided which extend from the apertures shown in Figure 6 to the edge of the substrate 203.

One skilled in the art will recognise that a number of solutions exist for providing the removable portions of upper solder mask 215. In particular, photolithography can be employed to distinguish the removable portions 215A from the rest of the upper solder mask 215. Electromagnetic radiation is used to change the properties of the removable portions 215A so that they can later be removed by chemical processing while leaving the rest of the upper solder mask 215 in tact.

The dotted line in Figure 6 represents the position at which the substrate 203 (including upper and lower solder mask 215, 216) will be cut in a later stage of the manufacturing process. This will be explained in more detail below, with reference to Figure 6B.

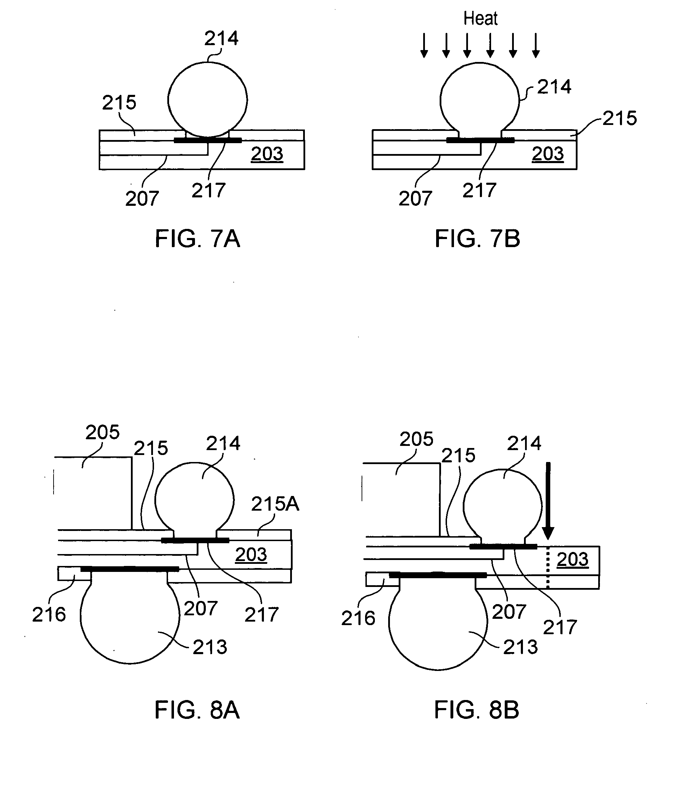

The apertures in the upper solder mask 215 receive the solder balls 214, and this is illustrated in Figures 7A and 7B. In order to secure a solder ball 214 in an aperture it is first placed into position as shown in Figure 7A. Heat is then applied to the solder ball 214 causing it to adhere to the substrate 203, as shown in Figure 7B.

Figures 7A and 7B illustrate a metal pad 217 disposed beneath the aperture in the upper solder mask 215. This is used to contact the solder ball 214 to an electrically conductive element 207 which runs through the substrate 203 from the solder ball 214 to the conductive bumps 210 on the integrated circuit die 204 (shown in, for example, Figure 4).

Figure 8A shows a side view of a solder ball 214 once it has been soldered to the substrate 203. The cross section of a removable portion 215A of the upper solder mask 215 is illustrated extending from the solder ball 214 to the edge of the substrate 203.

The next step in the manufacturing process is the removal of the removable portions 215A of the upper solder mask 215. This may typically be achieved through chemical processing or etching. The resulting arrangement is illustrated in Figure 8B. Effectively, the removal of the removable solder mask 215A creates a channel from the solder ball 214 to the edge of the substrate 203. When the solder ball 214 melts, it will travel at least partly along this channel, towards the edge of the substrate 203. This will assist in creating the solder bridge between adjacent modules 202 described in relation to Figure 3 above. In this way, the channel formed by the removal of the removable portion 215A of the upper solder mask 215 acts as a guide which directs molten solder from the solder ball 214 over an edge of the substrate 203. The guide also inhibits the flow of molten solder across the substrate 203 from the solder ball 214 in directions away from the edge of the substrate 203. This limits the possibility of short circuits being formed between adjacent solder balls 214 or any other electrical contacts.

In order to limit the distance across which solder balls 214 in adjacent substrates 203 are ultimately connected, the substrate 203 itself is then cut at the dotted line indicated in Figure 8B (this line corresponds with the dotted line shown in Figure 6). Cutting the substrate 203 at this point effectively shortens the length of the channels formed by the removal of the removable portions 215A of the upper solder mask 215 between the solder balls 214 and the edge of the substrate 203.

The result of the cutting process is illustrated from above in Figure 9. Figure 9 shows a number of solder balls 214 with channels extending from them to the edge of a substrate 203. To aid understanding, some of the solder balls 214 are illustrated as transparent with only a dotted outline showing. The skilled person will easily recognise that this is for illustrative purposes only, to assist in identifying the apertures in the upper solder mask 215 and the channels extending therefrom.

In Figure 9 a plurality of solder balls 214 are shown in an array extending along one side of the substrate 203. However, one skilled in the art will appreciate that the principles may apply to different numbers of solder balls 214, and that solder balls 214 may also be disposed on more than one side of the substrate 203.

As mentioned above, the first preferred embodiment manufactured in accordance with the principles and techniques described with relation to Figures 6 to 9 is illustrated in Figure 4.

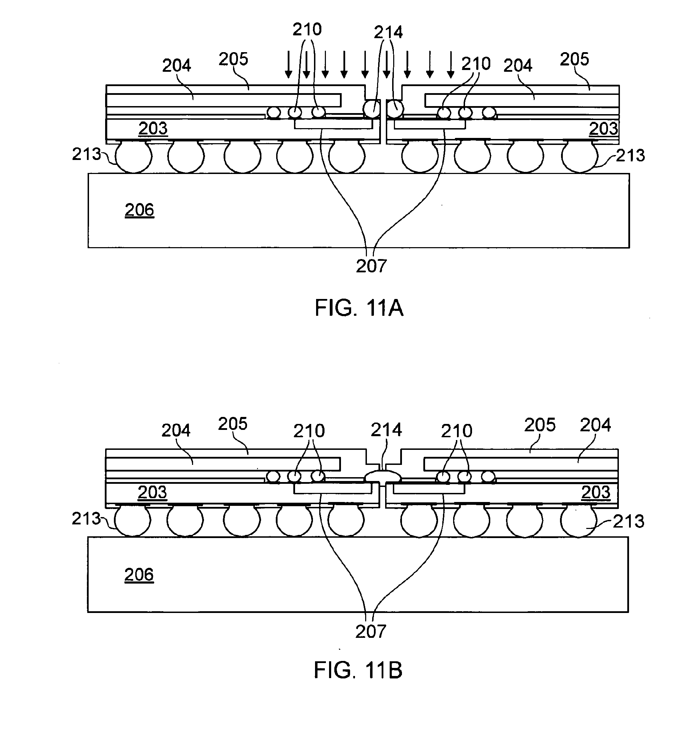

The second preferred embodiment is illustrated in Figure 5, and this is discussed in more detail above. One skilled in the art will recognise that a number of the steps for manufacturing the first embodiment may also be applied in the manufacture of the second embodiment. Nevertheless, some steps specific to the manufacture of the second embodiment are now described with reference to Figures 10 and 11.

As mentioned above, in the second embodiment the solder balls 214 are substantially covered by the moulding 205. Accordingly, once the solder balls 214 have been mounted to the substrate 203 (in the manner described with relation to Figures 6A and 6B above), the moulding 205 is formed such that it surrounds the solder balls 214. Typically, the moulding 205 used for this purpose is the same as the moulding 205 used to support the integrated circuit die 204. However, separate mouldings 205 may be provided to surround the solder balls 214 and the integrated circuit die 204.

Once the moulding 205 has been formed around the solder balls 214, its upper surface is ground down to the point at which openings are formed in the upper surface of the moulding 205 through which the solder balls 214 are exposed. Figure 10A illustrates the moulding 205 after this grinding step. As shown in Figure 10A, the grinding results in a stepped portion of the moulding 205 coinciding with the upper surface of the solder balls 214.

After the grinding step, a cutting process occurs to remove a section of the moulding 205, the substrate 203, and potentially the solder balls 214. The section cut from the module 202 during this step in the second preferred embodiment is shown in Figure 10B. As can be seen from Figure 10B, substantially all the moulding 205 on the outer surface of the solder balls 214 is cut away, along with corresponding portions of the substrate 203, the metal pad 217, and part of the solder balls 214 themselves.

As a result of the cutting process, parts of the solder balls 214 are exposed from the moulding 205 in a direction facing the edge of the substrate 203. That is to say, opening are formed in the moulding 205 between the solder balls 214 and the edge of the substrate. At the same time, any given solder ball 214 is isolated from the other solder balls 214 on the same substrate 203 by the moulding 205 which surrounds them. This helps to ensure that the solder balls 214 on a given module 202 are electrically isolated. It is therefore possible for melting of the solder balls 214 to be used to facilitate connections between solder balls 214 on adjacent modules 202 without risking unwanted contact being made between solder balls 214 on the same module 202.

In this manner, the moulding 205 acts as a guide to direct a flow of molten solder from the upper solder balls 214 over an edge of the substrate 203.

Figures 11A and 11 B illustrate the how the solder balls 214 on two modules 202 according to the second preferred embodiment may form an electrical connection. The connection acts to electrically couple the integrated circuit dies 204 of the two modules 202. In Figure 11A, the two modules 202 are placed adjacent to each other. However, no connection is formed at this stage because a gap between the solder balls 214 of the two modules 202 is maintained.

Heat is then applied from above to the region in which the modules 202 meet. As a result, the solder balls 214 of each module 202 melt, causing them to create an electrical connection in the form a solder bridge between the two modules 202, thereby electrically coupling the upper surfaces 208 of the substrates 203. The connection is a solder bridge. The guides formed by the mouldings 205 surrounding the solder balls 214 on each module 202 control the flow of molten solder to ensure the solder bridge is built. Moreover, the mouldings 205 ensure that the flow of molten solder does not form unwanted connections between solder balls 214 (such as connections between solder balls 214 on the same module 202).

Other variations and modifications will be apparent to the skilled person. Such variations and modifications may involve equivalent and other features which are already known and which may be used instead of, or in addition to, features described herein. Features that are described in the context of separate embodiments may be provided in combination in a single embodiment. Conversely, features which are described in the context of a single embodiment may also be provided separately or in any suitable subcombination.

It should be noted that the term "comprising" does not exclude other elements or steps, the term "a" or "an" does not exclude a plurality, a single feature may fulfil the functions of several features recited in the claims and reference signs in the claims shall not be construed as limiting the scope of the claims. It should also be noted that the Figures are not necessarily to scale; emphasis instead generally being placed upon illustrating the principles of the disclosure.

## Claims

1. An electronic device (201) comprising:
a first module (202) having a first substrate (203) with an upper surface (208) upon which a first integrated circuit die (204) is supported;
a second module (202) having a second substrate (203) with an upper surface (208) upon which a second integrated circuit die (204) is supported; and
an electrical connection comprising a bridge extending between the upper surface (208) of the first substrate (203) and the upper surface (208) of the second substrate (203).

2. An electronic device as claimed in claim 1, wherein the first and second substrates (203) are disposed on a carrier (206) adjacent to each other.

3. An electronic device as claimed in claim 1 or claim 2, wherein the electrical connection is solder.

4. A method of manufacturing an electronic device, the method comprising:
providing a first module (202) having a first substrate (203) with an upper surface (208) upon which a first integrated circuit die (204) is supported;
providing a second module (202) having a second substrate (203) with an upper surface (208) upon which a second integrated circuit die (204) is supported; and
forming an electrical connection comprising a bridge extending between the upper surface (208) of the first substrate (203) and the upper surface (208) of the second substrate (203).

5. A method according to claim 4, wherein the first and second substrates (203) are provided on a carrier (206) adjacent to each other.

6. A method according to claim 4 or claim 5, wherein the electrical connection is solder.

7. A method according to claim 6, wherein forming the electrical connection comprises heating solder balls (214) provided on the first and second upper surfaces (208) such that they melt to provide flows of molten solder that extend over edges of the first and second substrates (203).
